Europäisches Patentamt

European Patent Office

Office européen des brevets

(11) Publication number: **0 089 814**
**B1**

(12) **EUROPEAN PATENT SPECIFICATION**

(45) Date of publication of patent specification: **24.05.89**

(51) Int. Cl.⁴: **H 01 L 23/52,** H 01 L 21/90

(21) Application number: **83301490.5**

(22) Date of filing: **17.03.83**

(54) Method of forming fusible links in a semiconductor device.

(30) Priority: **18.03.82 JP 43746/82**

(43) Date of publication of application:
**28.09.83 Bulletin 83/39**

(45) Publication of the grant of the patent:
**24.05.89 Bulletin 89/21**

(84) Designated Contracting States:
**DE FR GB**

(56) References cited:
**EP-A-0 013 728**
**EP-A-0 025 347**
**US-A-4 042 950**
**US-A-4 242 698**

(73) Proprietor: **FUJITSU LIMITED**
**1015, Kamikodanaka Nakahara-ku**
**Kawasaki-shi Kanagawa 211 (JP)**

(72) Inventor: **Yabu, Takashi**
**1820-9, Kitahassaku-cho**
**Midori-ku Yokohama-shi Kanagawa 226 (JP)**
Inventor: **Kanazawa, Masao**
**4-305, 1540-1 Nakanoshima**
**Tama-ku Kawasaki-shi Kanagawa 214 (JP)**

(74) Representative: **Rackham, Stephen Neil et al**
**GILL JENNINGS & EVERY 53-64 Chancery Lane**
**London WC2A 1HN (GB)**

## Description

This invention relates to a method of producing a semiconductor device and more particularly to a method of forming fuses in an integrated circuit. It can be suitably applied to the formation of polycrystalline silicon fuses in a large-scale integration (LSI) memory.

The total number of bits of a large capacity LSI memory, such as a 64K-bit dynamic random-access memory, has been rapidly increased recently. In order to improve the yield, a redundancy organisation is incorporated into the memory. The redundancy organisation comprises spare rows and spare columns which are formed near a memory array. If a defective memory element (i.e. a defective bit) is generated, the row and the column forming the defective memory element are replaced with a spare (redundant) row and column. Replacement of the defective memory element is carried out by selectively blowing fuses (i.e. fusible links) which are provided in the memory device. The fuses are made of, for example, polycrystalline silicon and are blown by an excess electric current or by laser beam irradiation.

A conventional method of producing a semiconductor device comprises the steps of forming a fuse layer on an insulating layer; forming an insulating protective layer over the fuse layer; and selectively etching the insulating protective layer over the fuse layer to form a window, the insulating layer and the insulating protective layer having a similar etching behaviour with respect to the etchant used to etch the insulating protective layer. (See, e.g. EP—A—0025347). An example of this conventional method will be described in detail later.

In US—A—4042950 an etch-stop layer is provided between a patterned poly Si layer and an insulating protective layer to prevent inadvertent etching of the polysilicon.

According to a first aspect of this invention an interrupting layer which interrupts the etching process during the selective etching of the insulating protective layer is interposed between a fuse layer and the insulating protective layer and etching of the insulating protective layer exposes a portion of the interrupting layer, the interrupting layer then being etched with a different etchant to complete the window. This prevents the etchant used to etch the insulating protective layer from inadvertently also etching the insulating layer.

According to a second aspect of this invention a method of producing a semiconductor device is characterised by the steps of forming a polycrystalline silicon fuse layer on a first insulating layer; forming a second insulating layer on the fuse layer; depositing a second polycrystalline silicon layer on the second insulating layer and on the first insulating layer; patterning the second polycrystalline silicon layer to leave the patterned polysilicon layer over the fuse layer and a portion of the first insulating layer; forming an insulating protective layer covering the patterned second polycrystalline silicon layer; etching a portion of the protective layer above the region in which the fuse is formed to thereby expose a portion of the second polycrystalline silicon layer, the first insulating layer and the insulating protecting layer having a similar etching behaviour with respect to the etchant used to etch the insulating protective layer, and thus the polycrystalline silicon layer prevents the etchant used for etching the insulating protective layer from inadvertently also etching the first insulating layer; and, etching the exposed portion of the second polycrystalline silicon layer with a different etchant and also thereby etching an exposed portion of the second insulating layer to expose a portion of the fuse layer.

An embodiment of the invention will now be described and contrasted with the prior art with reference to the accompanying drawings, in which:-

Figure 1 is a partial plan view of a semiconductor device provided with a fuse according to the prior art;

Figure 2 is a sectional view along a line II—II of Figure 1;

Figures 3 to 11 are partially sectional views of a semiconductor device, provided with a fuse and a one-transistor memory cell, in various stages of production by means of a method in accordance with the present invention; and

Figure 12 is a plan view of a fuse of the semiconductor device shown in Figure 11.

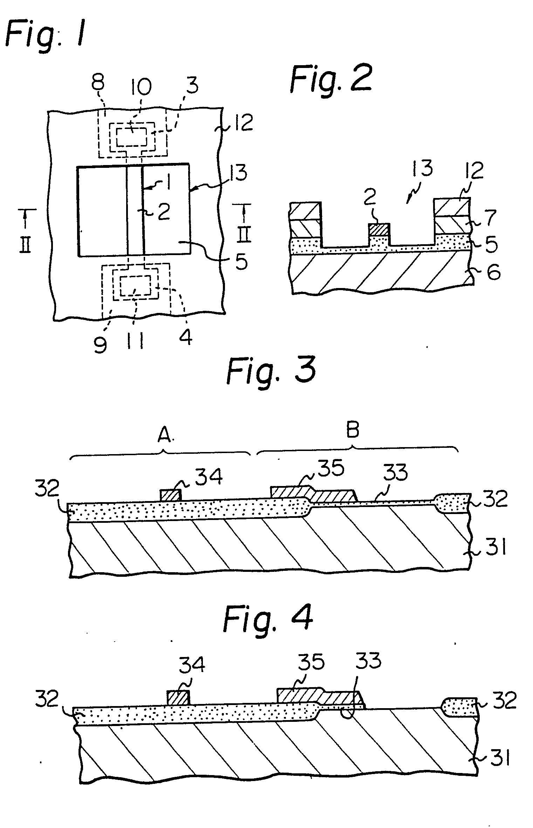

In a conventional method of producing a semiconductor device polycrystalline silicon fuses are formed around a memory array in an LSI memory chip. One of the fuses illustrated in Figures 1 and 2 of the accompanying drawings. As Figure 1 shows, a fuse 1 comprises a narrow centre portion 2 and wide end portions 3 and 4. The fuse 1 is formed by depositing a polycrystalline silicon layer on an insulating layer 5 of, for example, silicon dioxide (SiO$_2$) formed on a semiconductor substrate 6 of, for example, a silicon single crystalline wafer (Figure 2) and by selectively etching the polycrystalline silicon layer. Then an insulating layer 7 of, for example, phosphosilicate glass (PSG) for insulating the polycrystalline silicon layer and a subsequently-formed aluminium layer are formed on the fuse 1 and on the insulating layer 5 (Figure 2). Conductors 8 and 9 (Figure 1) are formed by depositing a conductor layer of, for example, aluminium on the insulating layer 7 and by selectively etching the conductor layer by means of a photoetching method. The conductors 8 and 9 are connected to the wide end portions 3 and 4, respectively, via through holes 10 and 11 formed in the insulating layer 7. A passivation layer 12 of, for example, PSG is formed on the whole surface of the obtained memory devices.

In order to permit easy and reliable blowing of the fuse 1, the passivation layer 12 and the insulating layer 7 are selectively etched to form a window 13 by which the narrow centre portion 2 is exposed. In this case since the SiO$_2$ of the

insulating layer 5 is akin to the PSG of the layers 7 and 12, the SiO₂ layer 5 can be etched with an etchant used to etch the PSG layers 7 and 12. Furthermore, usually, the total thickness of the PSG layers 7 and 12 is about 2 μm and the thickness of the SiO₂ layer 5 is about 0.5 μm. Accordingly, during the formation of the window 13 by etching the PSG layers 7 and 12, the SiO₂ layer 5 can also be etched (as is shown in Figure 2) so that a portion of the semiconductor substrate 6 may be exposed. If the semiconductor substrate 6 is exposed by the window 13, when the fuse 1 is blown, short-circuiting may occur between the semiconductor substrate 6 and the blown fuse. When the SiO₂ layer 5 remains in a thin state, undesirable impurities, such as moisture and ions in the air, may penetrate into the semiconductor substrate 6 through the thin SiO₂ layer 5, with the result that the reliability of the LSI memory is decreased.

Referring to Figures 3 to 11, a method of forming a fuse in accordance with the present invention is explained in connection with a process for forming a one-transistor memory cell in an LSI memory. In this case the on-transistor memory cell has a double-polysilicon structure which is well known to a person with an ordinary skill in the art.

In Figure 3, "A" is a region in which a fuse is formed and "B" is a region in which a memory cell is formed. A silicon substrate 31 (i.e. a silicon single crystalline wafer) is selectively oxidized to form an insulating layer 32 of SiO₂ (i.e. a so-called field-insulating layer) having a thickness of, for example, about 500 nm. Furthermore, the silicon substrate 31 is also selectively oxidized to form a thin insulating layer 33 of SiO₂ for a capacitor. Then a polycrystalline silicon layer having a thickness of from 300 nm to 500 nm is deposited on the whole surface of the insulating layers 32 and 33 by means of a chemical vapour deposition (CVD) method and is selectively removed by means of a photo-etching method to form simultaneously a fuse layer 34 in the region A and a capacitor electrode 35 in the region B.

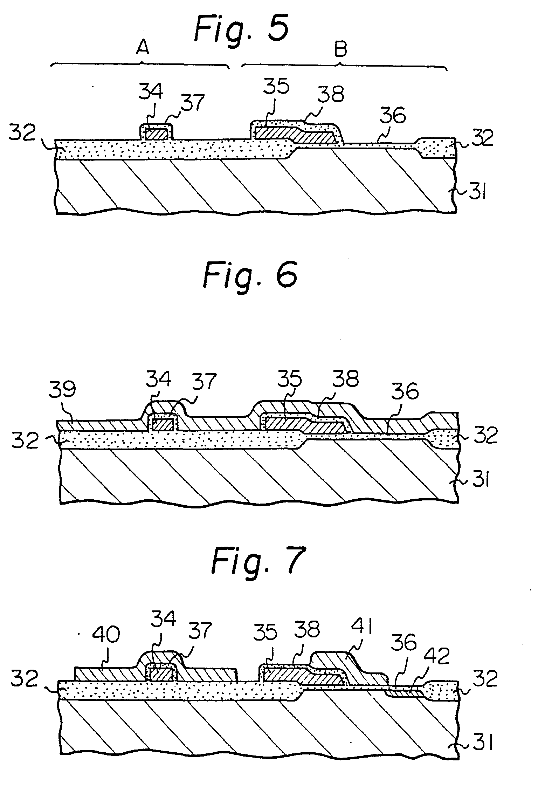

The exposed portion of the thin insulating layer 33 is also removed by means of a photoetching method, as shown in Figure 4. The exposed portion of the silicon substrate 31 is then thermally oxidized to form a gate oxide (SiO₂) layer 36 having a thickness of, for example, about 50 nm, as shown in Figure 5. At the same time, the fuse layer 34 and the capacitor electrode 35 of polycrystalline silicon are oxidized to form, respectively, SiO₂ insulating layers 37 and 38 having a thickness of about 100 nm.

Then another polycrystalline silicon layer 39, having a thickness of from 300 nm to 500 nm, is deposited on the whole surface of the SiO₂ layers 32, 36, 37 and 38 by means of a CVD method, as shown in Fig. 6. The polycrystalline silicon layer 39 is selectively removed by means of a photo-etching method to form simultaneously a polycrystalline silicon island 40 in the region A and a gate electrode 41 in the region B, as shown in Fig.

7. Then a doped region 42 (Fig. 7) is formed in the region B by implanting impurity ions in the silicon substrate 31 through the gate oxide layer 36.

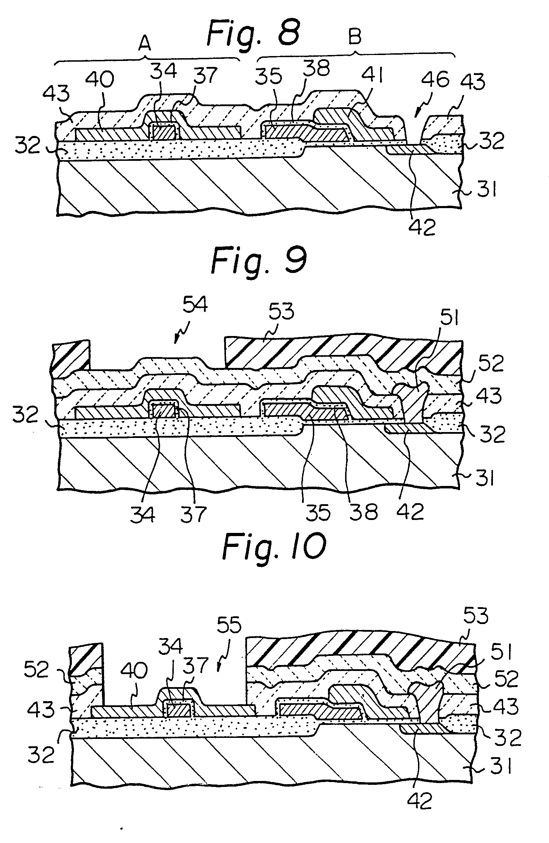

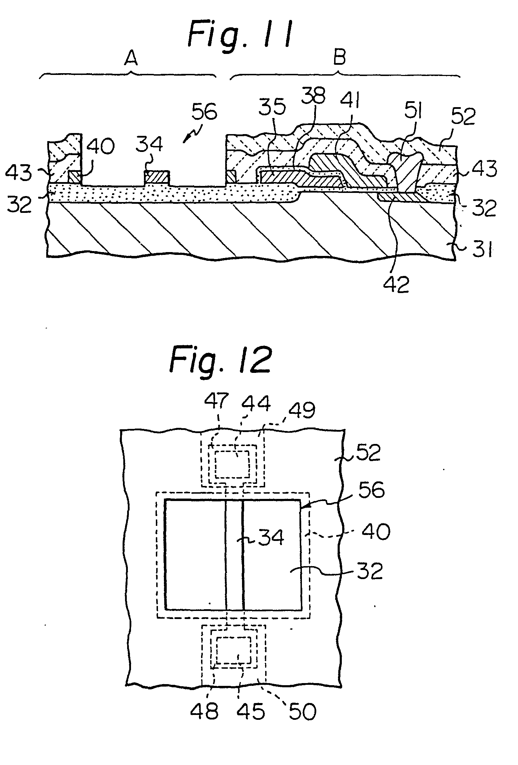

An isolation layer 43 of PSG having a thickness of, for example, about 1 μm is deposited on the whole surface of the obtained LSI memory by means of a CVD method, as shown in Fig. 8. The isolation layer 43 and the SiO₂ layers 37 and 36 are selectively removed by means of a photoetching method to form contact holes 44 and 45 (Fig. 12) in the region A and a contact hole 46 (Fig. 8) in the region B. Accordingly, in the contact holes 44 and 45, wide end portions 47 and 48, respectively, of the fuse layer 34 are exposed, and in the contact hole 46 a portion of the silicon substrate 31 in the doped region 42 is exposed.

Then a conductor layer of, for example, aluminium is formed on the isolation layer 43 and is patterned by means of a photoetching method to form conductors 49 and 50 (Fig. 12) and an electrode 51 (Fig. 9). The conductors 49 and 50 are connected to the wide end portions 47 and 48 through the contact holes 44 and 45, respectively. The electrode 51 is connected to the doped region 42 through the contact hole 46. A passivation layer 52 (i.e. an insulating protective layer) of PSG having a thickness of, for example, about 1 μm is deposited on the whole surface of the isolation layer 43, the conductors 47 and 48, and the electrode 51, as shown in Fig. 9. A photoresist layer 53 is formed on the passivation layer 52, is exposed to a patterned light, and is developed to form an opening 54 in the region A, as shown in Fig. 9. The dimensions of the opening 54 should be smaller than those of the polycrystalline silicon island 40.

The passivation layer 52 and the isolation layer 43 of PSG are selectively removed by means of a dry-etching treatment using trifluoromethane (CHF₃) gas as an etchant to form a partial window 55, as shown in Fig. 10. Since the polycrystalline silicon island 40 is not etched by the etchant, a portion of the island 40 is exposed by the partial window 55 and prevents the etching step from proceeding further. Then the exposed portion of the polycrystalline silicon island 40 is removed by means of a dry-etching treatment using carbon tetrafluoride (CF₄) gas as an etchant, so that an annular portion of the island 40 remains, as shown in Figs. 11 and 12. Next, the dry-etching treatment using the CHF₃ gas is repeated to remove the insulating layer 37 of SiO₂ so as to expose the fuse layer 34 through a window 56, as shown in Fig. 11. At the same time, the exposed portion of the insulating layer 32 is inevitably etched by the same thickness (about 100 nm) as that of the insulating layer 37. Since the thickness of the layer 37 is relatively thin, the time necessary for etching can be easily controlled, and it is possible to prevent excessive etching. Since the layer 32 has a thickness of about 500 nm, a portion of the silicon substrate 31 under the layer 32 cannot be exposed. The above-mentioned three dry-etching treatments can be performed in a dry-etching apparatus by changing the etchant gas. During the etching treatments, the photoresist layer 53 is not removed. Later, the photoresist layer 53 is removed with a suitable solvent or by means of an ashing method. Thus, a fuse and a one-transistor memory cell are simultaneously formed, as shown in Fig. 11, in accordance with the conventional steps for forming a double-polysilicon memory cell.

In carrying out the present invention, the insulating layer 32, which is exposed by the window 56 and lies on the substrate 31, is not removed completely. During removal of the insulating layer 37 only a small proportion of the thickness of the insulating layer 32 is removed and the remaining thickness of the insulating layer 32 is sufficient to prevent undesirable impurities from penetrating it, thus preventing deterioration of the reliability of the LSI memory.

In a testing method for detecting defective elements, the obtained fuse can be blown by passing an electric current therethrough or by laser beam irradiation thereon. After the fuse-blowing operation, the window 56 is covered with PSG, if necessary.

It is possible to form the fuse without forming a memory cell.

The fuse layer can be made of a metal silicide, such as molybdenum silicide, or tungsten silicide, instead of polycrystalline silicon. Another insulating layer can be made of PSG instead of $SiO_2$. It is possible to make the island 40 of a metal silicide (such as molybdenum silicide or tungsten silicide) or a metal (such as molybdenum, or tungsten) instead of polycrystalline silicon. Furthermore, it is possible to make the isolation layer and the passivation layer of $SiO_2$ instead of PSG.

## Claims

1. A method of producing a semiconductor device comprising the steps of forming a fuse layer (34) on an insulating layer (32); forming an insulating protective layer (43) over the fuse layer (34); and selectively etching the insulating protective layer (43) over the fuse layer to form a window (56), the insulating layer (32) and the insulating protective layer (43) having a similar etching behaviour with respect to the etchant used to etch the insulating protective layer (43), characterised in that an interrupting layer (40) which interrupts the etching process during the selective etching of the insulating protective layer (43) is interposed between the fuse layer (34) and the insulating protective layer (43) and in that etching of the insulating protective layer (43) exposes a portion of the interrupting layer (40) and the interrupting layer (40) then being etched with a different etchant to complete the window (56), to prevent the etchant used for etching the insulating protective layer (43) from inadvertently also etching the insulating layer (32).

2. A method according to claim 1, characterised in that the interrupting layer (40) comprises a conductor layer for interconnecting electrodes.

3. A method according to claim 1 or claim 2, characterised in that after the step of forming the fuse layer (34), another insulating layer (37) is formed between the fuse layer and the interrupting layer (40).

4. A method according to any preceding claim characterised in that the step of forming the interrupting layer (40) comprises a step of patterning the interrupting layer so that it has an island-like shape and is larger than the partial window (55).

5. A method according to claim 2, characterised in that the conductor layer (40) is made of polycrystalline silicon.

6. A method according to claim 2, characterised in that the conductor layer (40) is made of a metal silicide.

7. A method of producing a semiconductor device, characterised by the steps of forming a polycrystalline silicon fuse layer (34) on a first insulating layer (32); forming a second insulating layer (37) on the fuse layer (34); depositing a second polycrystalline silicon layer (40) on the second insulating layer (37) and on the first insulating layer (32); patterning the second polycrystalline silicon layer (40) to leave the patterned polysilicon layer over the fuse layer (34) and a portion of the first insulating layer (32); forming an insulating protective layer (43) covering the patterned second polycrystalline silicon layer (40); etching a portion of the protective layer (43) above the region in which the fuse is formed to thereby expose a portion of the second polycrystalline silicon layer (40), the first insulating layer (32) and the insulating protecting layer (43) having a similar etching behaviour with respect to the etchant used to etch the insulating protective layer (43), and thus the polycrystalline silicon layer (40) prevents the etchant used for etching the insulating protective layer (43) from inadvertently also etching the first insulating layer (32) and, etching the exposed portion of the second polycrystalline silicon layer (40) with a different etchant and also thereby etching an exposed portion of the second insulating layer (37) to expose a portion of the fuse layer (34).

## Patentansprüche

1. Verfahren zur Herstellung einer Halbleitervorrichtung mit den folgenden Schritten: Bildung einer Schmelzschicht (34) auf einer isolierenden Schicht (32); Bildung einer isolierenden Schutzschicht (43) auf der Schmelzschicht (34); und selektives Ätzen der isolierenden Schutzschicht (43) über der Schmelzschicht, um ein Fenster (56) zu formen, wobei die isolierende Schicht (32) und die isolierende Schutzschicht (43) ein ähnliches Ätzverhalten in Bezug auf das Ätzmittel haben, das verwendet wird, um die isolierende Schutzschicht (43) zu ätzen, dadurch gekennzeichnet, daß eine Unterbrechungsschicht (40), die den Ätzprozeß während des selektiven Ätzens der isolierenden Schutzschicht (43) unterbricht, zwischen der Schmelzschicht (34) und der isolierenden Schutzschicht (43) angeordnet ist und daß das Ätzen der isolierenden Schutzschicht (43) einen Abschnitt der Unterbrechungsschicht (40) exponiert und die Unterbrechungsschicht (40) dann mit einem anderen Ätzmittel geätzt wird, um das Fenster (56) zu vervollständigen, um zu verhindern, daß das Ätzmittel, das zum Ätzen der isolierenden Schutzschicht (43) verwendet wird, unbeabsichtigt auch die isolierende Schicht (32) ätzt.

2. Verfahren nach Anspruch 1, dadurch gekennzeichnet, daß die Umterbrechungsschicht (40) eine Leitungsschicht für zwischenverbindende Elektroden umfaßt.

3. Verfahren nach Anspruch 1 oder 2, dadurch gekennzeichnet, daß nach dem Schritt der Bildung der Schmelzschicht (34) eine andere isolierende Schicht (37) zwischen der Schmelzschicht und der Unterbrechungsschicht (40) geformt wird.

4. Verfahren nach einem der vorhergehenden Ansprüche, dadurch gekennzeichnet, daß der Schritt der Bildung der Unterbrechungsschicht (40) einen Schritt der Musterung der Unterbrechungsschicht umfaßt, so daß sie eine inselartige Form hat und größer als das Teilfenster (55) ist.

5. Verfahren nach Anspruch 2, dadurch gekennzeichnet, daß die Leitungsschicht (40) aus kristallinem Silizium besteht.

6. Verfahren nach Anspruch 2, dadurch gekennzeichnet, daß die Leitungsschicht (40) aus Metallsilicid besteht.

7. Verfahren zur Herstellung einer Halbleitervorrichtung, gekennzeichnet durch die Schritte der Bildung einer polykristallinen Siliziumschmelzschicht (34) auf einer ersten isolierenden Schicht (32); Bildung einer zweiten isolierenden Schicht (37) auf der Schmelzschicht (34); Abscheiden einer zweiten polykristallinen Siliziumschicht (40) auf der zweiten isolierenden Schicht (37) und auf der ersten isolierenden Schicht (32); Mustern der zweiten polykristallinen Siliziumschicht (40) um die gemusterte Polysiliziumschicht über der Schmelzschicht (34) und einem Abschnitt der ersten isolierenden Schicht (33) zu lassen; Bilden einer isolierenden Schutzschicht (43), welche die gemusterte zweite polykristalline Siliziumschicht (40) bedeckt; Ätzen eines Abschnitts der Schutzschicht (43) oberhalb des Bereiches, in welchem die Schmelze geformt wird, um dadurch einen Abschnitt der zweiten kristallinen Siliziumschicht (40) zu bilden, wobei die erste isolierende Schicht (32) und die isolierende Schutzschicht (43) ähnliches Ätzverhalten in Bezug auf das Ätzmittel haben, das verwendet wird, um die isolierende Schutzschicht (43) zu ätzen und so verhindert die polykristalline Siliziumschicht (40), daß das Ätzmittel, welches zum Ätzen der isolierenden Schutzschicht (43) verwendet wird, unbeabsichtigt auch die erste isolierende Schicht (32) ätzt; und Ätzen des exponierten Abschnitts der zweiten polykristallinen Siliziumschicht (40) mit einem anderen Ätzmittel und dadurch auch Ätzen eines exponierten Abschnitts der zweiten isolierenden Schicht (37), um einen Abschnitt der Schmelzschicht (34) zu exponieren.

## Revendications

1. Procédé de fabrication d'un dispositif à semiconducteur, comprenant les étapes suivantes: la formation d'une couche de fusibles (34) sur une couche isolante (32), la formation d'une couche protectrice isolante (43) sur la couche de fusibles (34), et l'attaque sélective de la couche protectrice isolante (43) sur la couche de fusibles afin qu'une fenêtre (56) soit formée, la couche isolante (32) et la couche protectrice isolante (43) ayant un comportement analogue vis-à-vis du matériau d'attaque utilisé pour l'attaque de la couche protectrice isolante (43), caractérisé en ce qu'une couche d'interruption (40) qui interrompt l'opération d'attaque pendant l'attaque sélective de la couche protectrice isolante (43) est disposée entre la couche de fusibles (34) et la couche protectrice isolante (43), et en ce que l'attaque de la couche protectrice isolante (43) expose une partie de la couche d'interruption (40) et la couch d'interruption (40) est alors attaquée par une matière différente d'attaque afin que la fenêtre (56) soit terminée, si bien que la matière d'attaque utilisée pour l'attaque de la couche protectrice isolante (43) ne peut pas aussi attaquer intempestivement la couche isolante (32).

2. Procédé selon la revendication 1, caractérisé en ce que la couche d'interruption (40) est une couche conductrice destinée à l'interconnexion d'électrodes.

3. Procédé selon la revendication 1 ou 2, caractérisé en ce que, après l'étape de formation de la couche de fusibles (34), une autre couche isolante (37) est formée entre la couche de fusibles et la couche d'interruption (40).

4. Procédé selon l'une quelconque des revendications précédentes, caractérisé en ce que l'étape de formation de la couche d'interruption (40) comprend une étape de formation d'un dessin dans la couche d'interruption afin qu'elle ait une forme analogue à un îlot et qu'elle soit plus grande que la fenêtre partielle (55).

5. Procédé selon la revendicaton 2, caractérisé en ce que la couche conductrice (40) est formée de silicium polycristallin.

6. Procédé selon la revendication 2, caractérisé en ce que la couche conductrice (40) est formée d'un siliciure métallique.

7. Procédé de fabrication d'un dispositif à semiconducteur, caractérisé par les étapes suivantes: la formation d'une couche (34) de fusibles formée de silicium polycristallin sur une première couche isolante (32), la formation d'une seconde couche isolante (37) sur la couche de fusibles (34), le dépôt d'une seconde couche de silicium polycristallin (40) sur la couche isolante (37) et sur la première couche isolante (32), la formation d'un dessin dans la seconde couche de silicium polycristallin (40) afin que la couche de silicium polycristallin formant un dessin reste sur la couche de fusibles (34) et sur une partie de la première couche isolante (32), la formation d'une couche protectrice isolante (43) recouvrant la seconde couche de silicium polycristallin (40) formant un dessin, l'attaque d'une partie de la couche protectrice (43) au-dessus de la région dans laquelle le fusible est formé afin qu'une partie de la second couche de silicium polycristallin (40) soit exposée, la première couche isolante (32) et la couche protectrice isolante (43) ayant un comportement analoque vis-à-vis d'une matière d'attaque utilisée pour l'attaque de la couche protectrice isolante (43), si bien que la couche de silicium polycristallin (40) empêche l'attaque intempestive de la première couche isolante (32) par la matière utilisée pour l'attaque de la couche protectrice isolante (43), et l'attaque de partie exposée de la seconde couche de silicium polycristallin (40) par und matière différente d'attaque et, de cette manière, l'attaque d'une partie exposée de la seconde couche isolante (37) afin qu'une partie de la couche de fusibles (34) soit exposée.

Fig. 1

Fig. 2

Fig. 3

Fig. 4

EP 0 089 814 B1

Fig. 5

Fig. 6

Fig. 7

2

*Fig. 8*

*Fig. 9*

*Fig. 10*

# Fig. 11

# Fig. 12